# EUROPEAN PATENT APPLICATION

(11) **EP 4 800 923 A1**
(43) Date of publication of application: **02.09.2026**
(21) Application number: 25160685.1
(22) Date of filing: 27.02.2025
(51) Int. Cl.: H03K 17/082, H03K 17/693

(54) **RADIO FREQUENCY SWITCH DEVICE, WIRELESS COMMUNICATION DEVICE, METHOD**

(71) Applicant: Infineon Technologies AG, 85579 Neubiberg (DE)
(72) Inventor: SOLOMKO, Valentyn, 81479 München (DE); SYROIEZHIN, Semen, 91052 Erlangen (DE); VÖLKEL, Matthias, 82008 Unterhaching (DE)
(74) Representative: 2SPL Patentanwälte PartG mbB

(57) **Abstract**

Provided is a radio frequency, RF, switch device. The RF switch device includes a plurality of transistors arranged in series and a RF switch terminal configured to receive a control voltage for controlling a switch state of the RF switch. The RF switch device further includes decoupling circuitry configured to receive a reference voltage. The decoupling circuitry is configured to block a current path from the RF switch terminal to the decoupling circuitry in response to a voltage at the RF switch and the reference voltage satisfying a predetermined criterion.

## Description

### Field

The present disclosure relates to a radio frequency switch device, a wireless communication device, and a method.

### Background

RF (radio frequency) switches based on stacked MOSFETs (metal-oxide semiconductor field effect transistor) may be used in front-ends of cellular mobile devices, e.g., as antenna tuning switches. An antenna tuning switch may include multiple switch throws (e.g., one to ten) capable of handling RF voltages, e.g., in the range of 40 to 100 Volts, and a digital control and power management unit, e.g., monolithically integrated on a CMOS (complementary metal oxide semiconductor) die.

In such switches, leakage current may be present which tends to undesirably interfere with the control principle of the device. There is therefore a demand for RF switch devices in which this problem is negated at least in part.

### Summary

This demand may be satisfied by the subject-matter of the independent claims. Further embodiments or examples are given by the dependent claims, the drawings, and the following description.

According to a first aspect, the disclosure provides a RF switch device. The RF switch device comprises a RF switch comprising a plurality of transistors arranged in series and a RF switch terminal configured to receive a control voltage for controlling a switch state of the RF switch. The RF switch device further comprises decoupling circuitry configured to receive a reference voltage. The decoupling circuitry is configured to block a current path from the RF switch terminal to the decoupling circuitry in response to a voltage at the RF switch and the reference voltage satisfying a predetermined criterion.

According to a second aspect, the disclosure provides a wireless communication device comprising an RF switch device according to the first aspect.

According to a third aspect, the disclosure provides a method of operating an RF switch device. The RF switch device comprises a RF switch comprising a plurality of transistors arranged in series and a terminal configured to receive a control voltage for controlling a switch state of the RF switch. The RF switch device further comprises decoupling circuitry configured to receive a reference voltage. The method comprises blocking a current path from the RF switch terminal to the decoupling circuitry, if a voltage at the RF switch and the reference voltage satisfy a predetermined criterion.

### Brief description of the Figures

Some examples of apparatuses and/or methods will be described in the following by way of example only, and with reference to the accompanying figures, in which
Fig. 1a depicts an RF switch device according to the present disclosure;
Fig. 1b depicts a more detailed of the RF switch of the RF switch device of Fig. 1a;
Fig. 2 depicts the decoupling circuitry Fig. 1a and a current-voltage diagram for the decoupling circuitry;
Fig. 3 depicts an RF switch device according to the present disclosure with a bypass switch;
Fig. 4 depicts different implementations of decoupling circuitry and bypass switches according to the present disclosure;
Fig. 5a depicts an RF switch device according to the present disclosure with three terminals;
Fig. 5b depicts a diagram showing a functionality of the decoupling circuitry of Fig. 5a;
Fig. 6 depicts an RF switch device according to the present disclosure with a shunt capacitor;
Fig. 7 depicts a wireless communication device according to the present disclosure; and
Fig. 8 depicts a flowchart of a method according to the present disclosure.

### Detailed Description

Some examples are now described in more detail with reference to the enclosed figures. However, other possible examples are not limited to the features of these embodiments described in detail. Other examples may include modifications of the features as well as equivalents and alternatives to the features. Furthermore, the terminology used herein to describe certain examples should not be restrictive of further possible examples.

Throughout the description of the figures same or similar reference numerals refer to same or similar elements and/or features, which may be identical or implemented in a modified form while providing the same or a similar function. The thickness of lines, layers and/or areas in the figures may also be exaggerated for clarification.

When two elements A and B are combined using an "or", this is to be understood as disclosing all possible combinations, i.e. only A, only B as well as A and B, unless expressly defined otherwise in the individual case. As an alternative wording for the same combinations, "at least one of A and B" or "A and/or B" may be used. This applies equivalently to combinations of more than two elements.

If a singular form, such as "a", "an" and "the" is used and the use of only a single element is not defined as mandatory either explicitly or implicitly, further examples may also use several elements to implement the same function. If a function is described below as implemented using multiple elements, further examples may implement the same function using a single element or a single processing entity. It is further understood that the terms "include", "including", "comprise" and/or "comprising", when used, describe the presence of the specified features, integers, steps, operations, processes, elements, components and/or a group thereof, but do not exclude the presence or addition of one or more other features, integers, steps, operations, processes, elements, components and/or a group thereof.

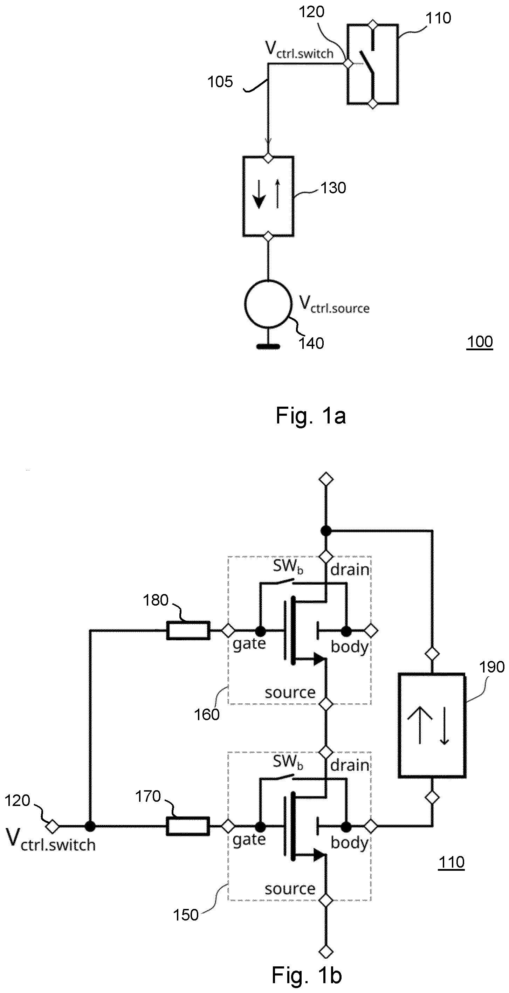

**Fig. 1a** depicts an RF switch device 100 according to the present disclosure. The RF switch 100 includes an RF switch 110 with an RF switch terminal 120.

The term "RF switch" may pertain to an electronic device configured to control a flow of highfrequency signals, allowing the signal to be directed, blocked, or rerouted between different paths. RF switches may be used in communication systems, radar, and signal testing to switch between antennas, signal paths, or different frequencies. RF switches may have the ability to operate at high frequencies, e.g., from a few MHz (e.g., starting at 1 MHz) to several GHz (e.g., up to 999 GHz), with minimal signal loss and high isolation between paths.

A "terminal" or "node" may refer to a point of connection to input a signal (e.g., apply a voltage/current) to the RF switch 110, such as a control voltage V_{ctrl.switch} for the RF switch 110. In Fig. 1, the RF switch terminal or control terminal 120 is displayed as a single point of connection but it should be noted that a signal line may also embody the RF switch terminal 120.

The control voltage V_{ctrl.switch} may be used to control a switch state of the RF switch 110, i.e., to establish one or multiple signal paths within the RF switch 110. Accordingly, the RF switch 110 may have multiple switch states, such as ON or OFF, but also sub-states (e.g., different ON states represented by different signal paths).

As depicted in **Fig. 1b****,** without limiting the present disclosure in that regard, the RF switch 110 includes a plurality of transistors arranged (e.g., coupled, connected) in series (i.e., meaning between respective gates of neighboring transistors). In Fig. 1b, only two transistors 150 and 160 are depicted, but more transistors may be used in other examples (e.g., depending on the number and the structure of signals to be established within the RF switch 110).

In some examples, the RF switch 110 is based on MOSFET technology, such that the transistors 150 and 160 are MOSFETs of a certain polarity depending on the circumstances. For example, the transistors 150 and 160 may be NMOS transistors, PMOS transistors, or the like. The RF switch may further include a resistive bias network providing DC bias voltages for the gates, bodies and source/drain terminals of the MOSFETS 150 and 160. The resistive bias network is exemplarily depicted as (high-ohmic) resistors 170 and 180 which may be respectively connected with gates of the MOSFETs 150 and 160 and which may be arranged in shunt configuration (i.e., arranged between the gate nodes and the terminal 120).

The RF switch 110 may be controlled by two voltage levels applied to the gates of the MOSFETs 150 and 160, wherein one voltage level may correspond to an ON-state and the other voltage level may correspond to an OFF-state of the RF switch 110. For example, a negative voltage may be applied in the OFF-state and a positive voltage may be applied in the ON-state. The bodies of the MOSFETs 150 and 160 may be DC-coupled to the respective gates. A dedicated switch SW_{b} (body bias switch) may be used for this purpose as depicted in Fig. 1b. When biased with negative voltage, a leakage current may flow from the source-drain terminals into the body terminals of each MOSFET 150 and 160. The leakage current may be dominated by so-called GIDL/GISL (Gate-Induced Drain Leakage/Gate-Induced Source Leakage) currents. The amount of leakage current may depend on a number of stacked MOSFETs 150 and 160 and a width of the MOSFETs 150 and 160. For antenna tuning switches, due to high RF voltage handling requirements and therefore large stack size and low ON-state resistance, the leakage current might be considerable (e.g., in the range of 1 µA to 50 µA), resulting in increased current consumption of the RF switch 110 or a device including the RF switch 110, e.g., when a monolithically-integrated charge pump is used which may have an efficiency of, for example, 10 - 20 %.

The leakage current might be reduced by reducing the absolute value of the negative control voltage (i.e., making control voltage less negative). However, this may result in degraded RF voltage handling capability of the switch, which may be proportional to an absolute value of the control voltage.

The RF switch 110 may (optionally) further include a leakage current compensation network 190 configured to reduce a self-biasing effect of the leakage current at high RF voltage excitations of the RF switch 110.

In other words, in some examples, the RF switch 110 further includes, for at least one pair of adjacent transistors of the series, a respective compensation circuit (e.g., the circuit 190) configured to provide a current path between the pair of adjacent transistors in a first direction and block the current path in a second direction opposite to the first direction. In Fig. 1b, the first direction may refer to the direction from the body of MOSFET 150 to the drain of MOSFET 160. The second direction may refer to the direction from the drain of MOSFET 160 to the body of MOSFET 150.

In some examples, the RF switch 110 may (optionally) further include a plurality of bootstrapping switches for each transistor (e.g., 150 and 160). A gate of a respective bootstrapping switch may be configured to operate the bootstrapping switch in a closed state and thus, short the body terminal with the gate terminal in the OFF-state of the RF switch 110.

In other words, in some examples, for at least one transistor of the plurality of transistors electrically connected in series, a bootstrapping circuit is electrically connected between a gate and a body of the at least one transistor and configured to electrically connect the body with the gate when the RF switch is in an OFF-state.

A bootstrapping switch may maintain a constant gate-source voltage, even if the source voltage changes. Moreover, in combination with leakage compensation according to the present disclosure, decrease of source-gate voltages may be prevented. For example, this may be achieved by using a bootstrapping capacitor that dynamically raises the gate voltage, ensuring low on-resistance, such as discussed in patent publication US10931275B2. It may allow the MOSFET to operate efficiently with low signal voltages, enhancing circuit accuracy and speed.

Returning to Fig. 1a, the RF switch device 100 further includes decoupling circuitry (or control decoupling circuitry) 130. As indicated above, leakage current may be present in a configuration discussed under reference of Fig. 1b, without limiting the present disclosure to the example of Fig. 1b. The leakage current may flow out of the RF switch 110 via the RF switch terminal 120. However, the decoupling circuitry 130 may be configured to block the leakage current, thereby reducing or stopping the leakage current.

The decoupling circuitry 130 is configured to receive a reference voltage V_{ctrl.source}. The reference voltage V_{ctrl. source} may relate to any voltage based on which the decoupling circuitry 130 blocks the current path 105 (as will be discussed below). In this example, a control voltage source 140 is depicted that is configured to supply the reference voltage V_{ctrl. source}, but the present disclosure is not limited in that regard.

The decoupling circuitry 130 is configured to block a current path 105 from the RF switch terminal 120 to the decoupling circuitry 130 in response to a voltage at the RF switch and the reference voltage V_{ctrl. source} satisfying a predetermined criterion.

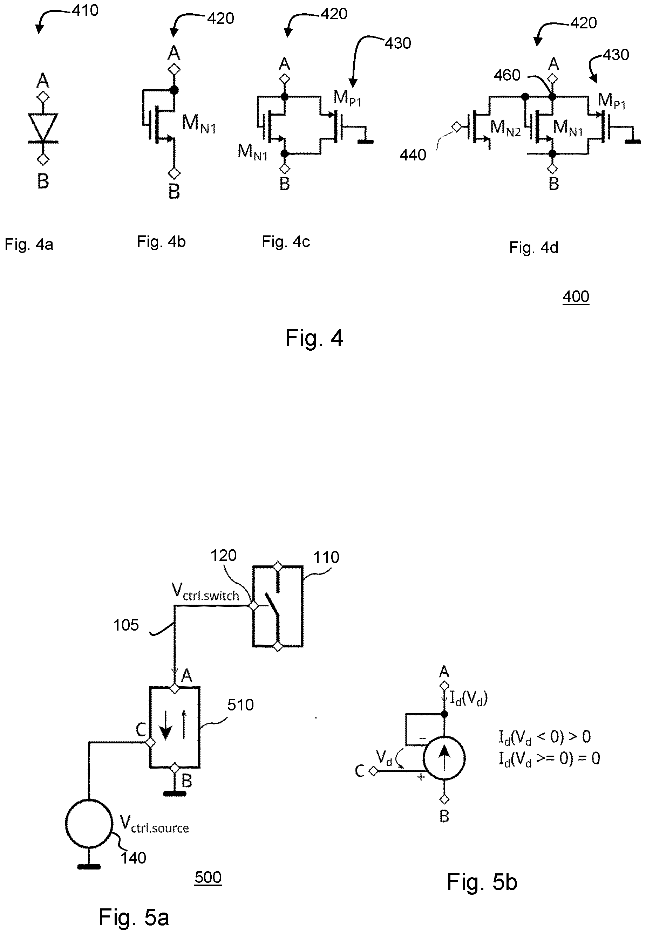

The predetermined criterion may include the relative voltage level that is reached at the terminal 120 compared to that of the reference voltage V_{ctrl. source}. For example, if the voltage at terminal 120 (e.g., the control voltage V_{ctrl.switch}) is lower than the reference voltage V_{ctrl.source}, the current path 105 may be blocked by the decoupling circuitry 130. On the other hand, the predetermined criterion may lead to a blocking of the current path 105 based on a different voltage, as will be discussed under reference with Fig. 5.

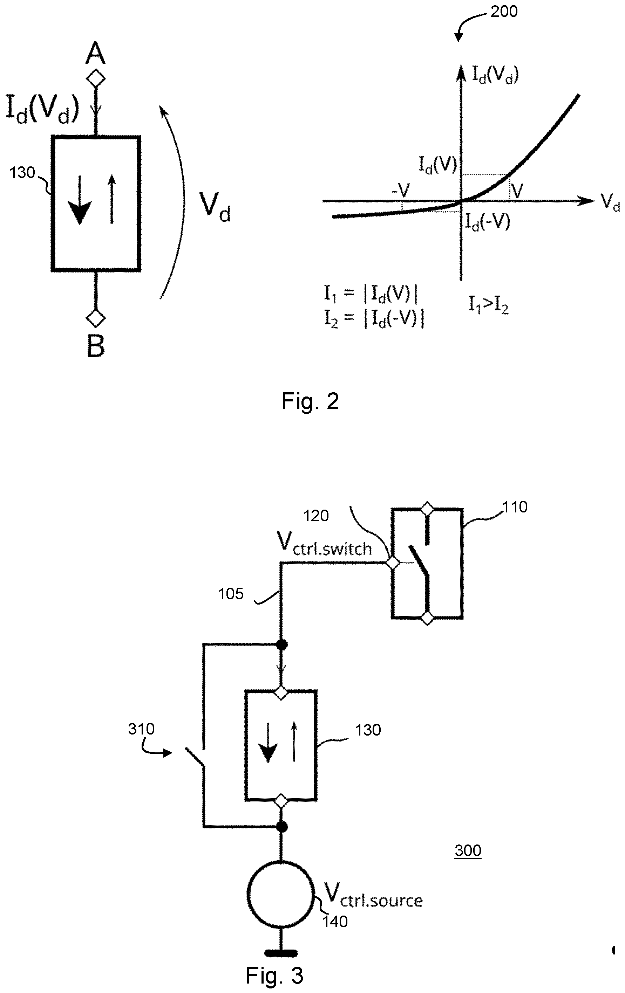

For example, the reference voltage V_{ctrl. source} may be representative of the control voltage V_{ctrl.switch}. For example, the reference voltage V_{ctrl. source} and the control voltage V_{ctrl.switch} may be (roughly) the same. In another example, the reference voltage V_{ctrl. source} may be based on the control voltage (V_{ctrl.switch}). In another example, the control voltage V_{ctrl.switch} may be based on the reference voltage V_{ctrl. source}. For example, the decoupling circuitry 130 may include a voltage divider (or any other means that) based on which the reference voltage V_{ctrl. source} is reduced (or changed) to the voltage at terminal 120 (e.g., the control voltage V_{ctrl.switch}, in instances where the RF switch 110 is actually controlled). In such an example, the predetermined criterion may include that a voltage at the RF switch terminal 120 is lower than or equal to the reference voltage V_{ctrl.switch}. In more general terms, the reference voltage V_{ctrl.switch} being representative of the control voltage V_{ctrl.switch} may refer to a case in which the control voltage V_{ctrl.switch} is generated based on the reference voltage V_{ctrl. source}. Also, a voltage across the two nodes (A and B as in Fig. 2 or 4, for example) of the decoupling circuitry 130 may correspond to the reference voltage. In such a case, the reference voltage may also be representative of the control voltage V_{ctrl.switch} since it may directly depend on the control voltage V_{ctrl.switch} (or the control voltage V_{ctrl.switch} may directly depend on the reference voltage).

In some examples, the decoupling circuitry 130 may be configured to provide the current path 105 from the decoupling circuitry 130 to the RF switch terminal when the criterion is not satisfied, e.g., when the reference voltage V_{ctrl.switch} is smaller or equal to the voltage at the terminal 120.

According to the present disclosure, current consumption of antenna tuning products may be reduced while, while sustaining/maintaining an RF performance of RF switches.

An RF switch, such as the RF switch 110, may be operated in an OFF-state or in an ON-state. In the OFF-state, there may be no (or small) signal RF excitation at the RF switch 110 or there may be large-signal RF excitation.

In case of no or small-signal RF excitation, the voltage at the source 140 may be negative, e.g., between -2V and -3V. Due to the finite leakage current (GIDL) in steady-state conditions of the RF switch 110 that is biased with negative voltage, the voltage at the terminal 120 may be more positive (or less negative) than the voltage at the source 140, with the difference defined by the leakage current flowing through the decoupling circuitry 130 (or 510). The overall leakage current of the device with the decoupling circuitry 130 (or 510) may be substantially smaller than the leakage current without a decoupling circuitry due to the voltage drop caused by the decoupling circuitry 130 (or 510) and the limiting effect of the decoupling circuitry 130 (or 510). Hence, according to the present disclosure, a reduction of leakage current and consequently, power consumption of the complete RF switch product may be achieved.

In case of large-signal RF excitation, the leakage compensation of the RF switch 110 together with the gate bootstrapping circuits may overdrive the bias voltage set by the source 140 on the terminal 120, pulling the reference voltage at the terminal 120 to a more negative voltage than initially set or even making it below the reference voltage V_{ctrl.switch} set by the source 140. This may be caused the leakage compensation described herein and may be amplified by a nonlinear IV (current-voltage) response of the decoupling circuitry 130 (or 510), which may block (or substantially reduce) the current when the negative voltage is applied across the decoupling circuitry 130 (or 510). Such behavior may allow achieving high RF voltage handling capability, enabled by the more negative voltage at the terminal 120 than set in the steady-state bias conditions without RF excitation.

**Fig. 2** depicts the decoupling circuitry 130 and a current-voltage (IV) diagram which depicts a response of the decoupling circuitry 130. In this example, the decoupling circuitry 130 may have a response like a diode (e.g., pn junction, MOSFET-based diode, or the like), but the present disclosure is not limited in that regard. As can be taken from Fig. 2, when a negative voltage V_{d} is applied across the decoupling circuitry 130, the current I_{d} flowing through the decoupling circuitry 130 may be below the current in the forward-biased circuit (i.e., when a positive voltage is applied), thereby blocking the leakage current I_{d}.

In some examples, the RF switch device 100 further includes a bypass switch arranged in parallel to the decoupling circuitry for bypassing the decoupling circuitry. Such a configuration is depicted in **Fig. 3** which depicts an RF switch device 300 which, compared to the device 100 of Fig. 1, further includes a bypass switch 310.

As indicated above, the bypass switch 310 is arranged in parallel to the decoupling circuitry 130. Moreover, the bypass switch 310, when in a closed (conductive) state, may be configured to short the terminals A and B of the decoupling circuitry, thereby bypassing the decoupling circuitry 130. This may be used in a case in which no leakage current is expected or in which current flowing to the RF switch 110 is expected to be (much) higher than the leakage current.

For example, the bypass switch may bypass the decoupling circuitry 130 in an ON-state of the RF switch or during switching transient.

The ON-state may refer to the condition when the RF switch 110 is closed (conductive), allowing RF signals to pass through with minimal insertion loss. In this state, the RF switch 110 may present low impedance, enabling efficient signal transmission from input to output.

Switching transient may refer to a temporary signal disturbance that may occur when the RF switch 110 transitions between different states (e.g., on/off or between paths). These disturbances may manifest as voltage or current spikes and may introduce noise or glitches into the overall system. Transients may be caused by parasitic capacitance, parasitic inductance, or impedance mismatches within the circuit.

**Fig. 4** depicts different examples of decoupling circuitry and bypass switches.

**Fig. 4a** depicts decoupling circuitry 410 as a diode configured to block the current path 105 from the decoupling circuitry 410 to the RF switch terminal 120. The diode may block the leakage current since the reverse voltage (or negative voltage) may need to be high enough in order for the diode to transmit the leakage current. Hence, the diode may be chosen to be adapted to this circumstance.

**Fig. 4b** depicts decoupling circuitry 420 as an NMOS transistor M_{N1} configured to implement a transmission gate (or pass gate). The transistor M_{N1} may be implemented as a diode-connected transistor, in some examples. Moreover, a control terminal 460 (in this example, the drain) of the transistor M_{N1} is electrically connected to the RF switch terminal 120. However, the present disclosure is not limited to such a configuration, if a transistor is used. For example, if PMOS transistor is used instead of an NMOS transistor, connections may be reversed.

**Fig. 4c** depicts the decoupling circuitry 420 and additionally, a bypass switch 430 is provided. In the present example, the bypass switch 430 includes a second transistor M_{P1} electrically connected in parallel to the first transistor M_{N1}. The second transistor M_{P1} is configured to provide a conductive path for bypassing the decoupling circuitry 420. In this example, the second transistor M_{P1} is a PMOS transistor, but the present disclosure is not limited in that regard. For example, in more general terms, the second transistor M_{P1} may have a different polarity than the first transistor M_{N1}.

The bypass switch 430 may switch into an ON state when the reference voltage V_{ctrl.switch} becomes positive and above a threshold voltage of the PMOS transistor M_{P1}. If the gate of M_{P1} is grounded, the positive voltage at terminal B of the decoupling circuitry 420 may bring the transistor to saturation, thereby opening a channel between the drain and source terminals, which may create a low-ohmic path between terminals A and B of the circuit.

**Fig. 4d** depicts the decoupling circuitry 420, the bypass switch 430, and additionally a third transistor M_{N2} (in this example, an NMOS transistor, but the present disclosure is not limited in that regard - it may have the same polarity as the first transistor or a different polarity). The second transistor M_{N2} is electrically connected in parallel to the first M_{N1} and the second transistor M_{P1}. A control terminal 440 (in this example, the gate) of the third transistor M_{N2} is configured to receive a control signal for selectively controlling the second transistor M_{P1} to provide the conductive path for bypassing the decoupling circuitry 420, thereby providing a switch for activating or deactivating the bypass switch.

In other words, the voltage at the gate of the transistor M_{N2} with respect to A and B may define the state of the bypass switch. For example, it may be brought to the ON state by applying positive voltage with respect to A and B. The enabling of the bypass switch may be used in the switching transient mode to reduce a resistance of the charge path and speed-up a charging process.

**Fig. 5a** depicts a further example of an RF switch device 500 according to the present disclosure. In contrast to the decoupling circuitry 130 of Fig. 1, the RF switch device 500 includes decoupling circuitry 510 including an additional terminal. In more detail, decoupling circuitry 510 includes terminals A, B, and C (also referred to as first terminal (A), second terminal (B), and third terminal (C)). Terminal A is connected to terminal 120, while terminal C is connected to voltage source 140. Terminal B is, in this example, connected to ground, but the present disclosure is not limited in that regard. It may be connected to a further voltage source or signal source, in some instances. Terminal B may define a threshold at which the decoupling circuitry 510 becomes conductive or isolative. On the other hand, the voltage at terminal C may provide a threshold defining the current through the circuit. In some examples, the decoupling circuitry 510 may be implemented as a voltage control current source. In such an example, the current path 105 may be conductive, if the threshold set at the input of terminal B is exceeded. For example, the decoupling circuitry 510may conduct current when the voltage across the A-C branch exceeds the defined level, and may prevent current flow otherwise. Setting a threshold in such a way, the overall current may depend on a difference between voltages at terminals A and C, or in mathematical terms current I=I(V(C)-V(A)). Hence, the criterion in this case may be a criterion relating to threshold of terminal B, e.g., the voltage across the branch A-C. For example, if the control/reference voltage is below a threshold across nodes A and C, the decoupling circuitry 510 may be configured to block the current path 105. For example, the threshold might be larger than zero (e.g., a current I(V(C)-V(A) > Vₜₕ) > 0). The threshold voltage Vₜₕ may be an internal characteristic (such as forward bias voltage of a pn diode, a threshold voltage of a MOS transistor, or the like), or may be based on voltage V(B).

**Fig. 5b** depicts a diagram showing the current I₄ flowing through the decoupling circuitry 510 as a function of the voltage V_{d} across that may define the current flowing from A to B. Thus, V_{d} may be defined as V(C)-V(A), as mentioned above. If V_{d} is smaller than zero, the current I_{d} is larger than zero. If V_{d} is larger or equal to zero, I_{d} is equal to zero when the decoupling circuitry 510 is used. In other words, a current path 105 for leakage current is blocked.

It should be noted that the principles of the present disclosure (e.g., the principles discussed under reference of Figs. 1 to 4, and Fig. 6) may also be applied to the example discussed under reference of Fig. 5. Generally, all the examples may be combined. For example, any of the bypass switches may be combined with any of the decoupling circuitry.

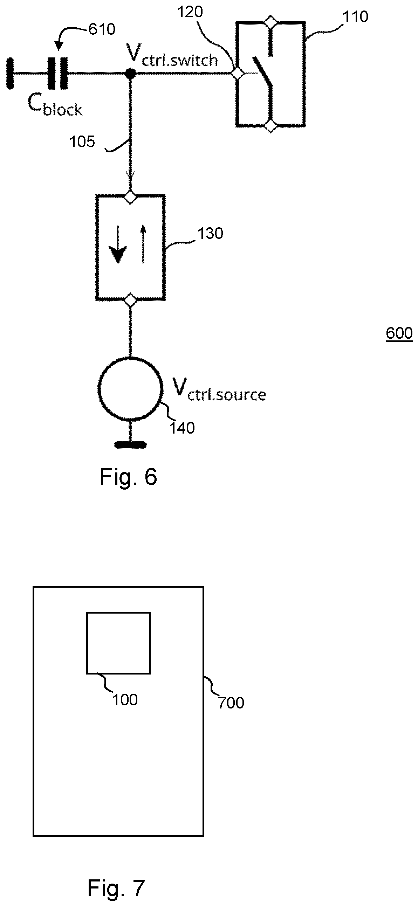

Figs. 5a and 5b are discussed herein for explaining that two functions (receiving reference voltage and conducting the current) may be separated into two (or more terminals) B and C of the decoupling circuitry instead of only one terminal as discussed under reference of Figs. 3 and 6. In the embodiment of Fig. 5, terminal C receives the reference voltage, and terminal B continues to conduct the current coming from terminal A.

**Fig. 6** depicts an RF switch device 600 according to the present disclosure. In Fig. 6, in addition the RF switch device 100 of Fig. 1, a shunt capacitor 610 is provided that is connected to the RF switch terminal 120 in parallel to the RF switch 110 (with respect to the decoupling circuitry 130). The RF voltage may couple into the decoupling circuitry 130 via terminal 120 of the RF switch 110 when the RF switch 110 is driven with a large RF signal. To protect the decoupling circuitry 130 from excessive RF voltage stress, the shunt capacitor 610 may be provided at the terminal 120 to block some or most of the amplitude of RF voltage at the terminal 120.

It should be noted that the present disclosure is not limited to a single capacitor as the shunt capacitor. Multiple capacitors and other electronic elements may be used, in some instances, such as resistors, inductances, transistors, diodes, and the like.

**Fig. 7** depicts a wireless communication device 700. In this example, the wireless communication device includes the RF switch device 100. However, in some examples a wireless communication device may include any other RF switch device, such as the RF switch device 300, 500, or 600. Also, multiple (same or different) RF switch devices may be included in a wireless communication device according to the present disclosure.

The wireless communication device 700 may be a cellular phone, such as any of a mobile phone, a feature phone, a smartphone, a phablet (hybrid device between a tablet and a smartphone), a wearable mobile device (e.g., smartwatch, smart glasses, smart earbuds/headphones, smart lenses, etc.), a tablet with cellular connectivity, a satellite phone, a mobile hotspot, a repeater, a router, an electronic reader, a connected vehicle (with integrated mobile communication capabilities), an IoT (internet of things) device with mobile connectivity (e.g., smart home devices, sensors, or the like), or the like. If the principles of the present disclosure are applied in cellular phones, high RF performance while low power consumption may be achieved.

In some examples, an RF switch device according to the present disclosure may be used in a wireless communication device to tune an antenna of the wireless communication device and to prevent leakage current, as discussed herein.

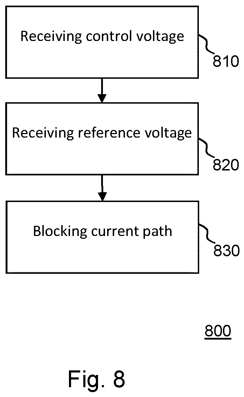

**Fig. 8** depicts a flowchart of a method 800 of operating an RF switch device, such as any of the RF switch devices discussed herein. The method 800 includes receiving, 810, a control voltage for controlling a switch state of the RF switch. The method 800 further includes receiving, 820, a reference voltage. The method 800 further includes blocking, 830, a current path from the RF switch terminal to the decoupling circuitry, if a voltage at the RF switch and the reference voltage satisfy a predetermined criterion. It should be noted that the receiving 810 and 820 may be optional method steps since the present disclosure pertains to blocking the current path in order to reduce leakage current, in some examples, regardless of whether the voltages are received. For example, an indication of control voltage and/or reference voltage may be sufficient decide whether the current path should be blocked.

The examples and embodiments described herein may be summarized as follows:
The aspects and features described in relation to a particular one of the previous examples may also be combined with one or more of the further examples to replace an identical or similar feature of that further example or to additionally introduce the features into the further example.

An example (e.g., example 1) relates to an RF switch. The RF switch device includes an RF switch including a plurality of transistors arranged in series and a RF switch terminal configured to receive a control voltage for controlling a switch state of the RF switch. The RF switch device further includes decoupling circuitry configured to receive a reference voltage. The decoupling circuitry is configured to block a current path from the RF switch terminal to the decoupling circuitry in response to a voltage at the RF switch and the reference voltage satisfying a predetermined criterion.

Another example (e.g., example 2) relates to a previous example (e.g., example 1) or to any other example. In this example, the decoupling circuitry is configured to provide the current path from the decoupling circuitry to the RF switch terminal when the criterion is not satisfied.

Another example (e.g., example 3) relates to a previous example (e.g., example 1 or 2) or to any other example. In this example, the RF switch device further includes a bypass switch arranged in parallel to the decoupling circuitry for bypassing the decoupling circuitry.

Another example (e.g., example 4) relates to a previous example (e.g., any one of examples 1 to 3) or to any other example. In this example, the reference voltage is representative of the control voltage and the predetermined criterion is that a voltage at the RF switch terminal is lower than or equal to the reference voltage.

Another example (e.g., example 5) relates to a previous example (e.g., example 4) or to any other example. In this example the decoupling circuitry includes a diode to block the current path from the decoupling circuitry to the RF switch terminal.

Another example (e.g., example 6) relates to a previous example (e.g., example 4 or 5) or to any other example. In this example the decoupling circuitry includes a first transistor different from the plurality of transistors of the RF switch. The first transistor is a diode-connected transistor and a control terminal of the diode-connected transistor is electrically connected to the RF switch terminal.

Another example (e.g., example 6) relates to a previous example (e.g., example 6 when relating to example 3) or to any other example. In this example, the bypass switch includes a second transistor electrically connected in parallel to the first transistor. The second transistor is configured to provide a conductive path for bypassing the decoupling circuitry.

Another example (e.g., example 8) relates to a previous example (e.g., example 7) or to any other example. In this example, the bypass switch further includes a third transistor electrically connected in parallel to the first transistor and the second transistor. A control terminal of the third transistor is configured to receive a control signal for selectively controlling the second transistor to provide the conductive path for bypassing the decoupling circuitry.

Another example (e.g., example 9) relates to a previous example (e.g., any one of examples 1 to 8). In this example, the RF switch device further includes, for at least one pair of adjacent transistors of the series, a respective compensation circuit configured to provide a current path between the pair of adjacent transistors in a first direction and block the current path in a second direction opposite to the first direction.

Another example (e.g., example 10) relates to a previous example (e.g., example 9) or to any other example. In this example, for at least one transistor of the plurality of transistors electrically connected in series, a bootstrapping circuit is electrically connected between a gate and a body of the at least one transistor and configured to electrically connect the body with the gate when the RF switch is in an OFF-state.

Another example (e.g., example 11) relates to a previous example (e.g., any one of examples 1 to 10) or to any other example. In this example, the RF switch device further includes a shunt capacitor electrically connected to the RF switch terminal in parallel to the RF switch.

An example (e.g., example 12) relates to a wireless communication device including an RF switch device according to any one of examples 1 to 11.

An example (e.g., example 13) relates to a method of operating an RF switch device (e.g., according to any one of examples 1 to 11). The RF switch device may include an RF switch including a plurality of transistors arranged in series, a terminal configured to receive a control voltage for controlling a switch state of the RF switch, and decoupling circuitry configured to receive a reference voltage. The method includes blocking a current path from the RF switch terminal to the decoupling circuitry, if a voltage at the RF switch and the reference voltage satisfy a predetermined criterion.

Another example (e.g., example 14) relates to a previous example (e.g., example 13) or to any other example. In this example, the RF switch device further includes a bypass switch arranged in parallel to the decoupling circuitry and the method includes bypassing the decoupling circuitry.

Another example (e.g., example 15) relates to a previous example (e.g., example 13 or 14) or to any other example. In this example, the method further includes providing the current path from the decoupling circuitry to the RF switch terminal when the criterion is not satisfied.

It is further understood that the disclosure of several steps, processes, operations or functions disclosed in the description or claims shall not be construed to imply that these operations are necessarily dependent on the order described, unless explicitly stated in the individual case or necessary for technical reasons. Therefore, the previous description does not limit the execution of several steps or functions to a certain order. Furthermore, in further examples, a single step, function, process or operation may include and/or be broken up into several sub-steps, -functions, -processes or -operations.

If some aspects have been described in relation to a device or system, these aspects should also be understood as a description of the corresponding method. For example, a block, device or functional aspect of the device or system may correspond to a feature, such as a method step, of the corresponding method. Accordingly, aspects described in relation to a method shall also be understood as a description of a corresponding block, a corresponding element, a property or a functional feature of a corresponding device or a corresponding system.

The following claims are hereby incorporated in the detailed description, wherein each claim may stand on its own as a separate example. It should also be noted that although in the claims a dependent claim refers to a particular combination with one or more other claims, other examples may also include a combination of the dependent claim with the subject matter of any other dependent or independent claim. Such combinations are hereby explicitly proposed, unless it is stated in the individual case that a particular combination is not intended. Furthermore, features of a claim should also be included for any other independent claim, even if that claim is not directly defined as dependent on that other independent claim.

## Claims

1. A radio frequency, RF, switch device (100; 300; 500; 600), comprising:
a RF switch (110) comprising a plurality of transistors (150, 160) arranged in series and a RF switch terminal (120) configured to receive a control voltage (V_{ctrl.switch}) for controlling a switch state of the RF switch (110); and
decoupling circuitry (130; 420; 510) configured to receive a reference voltage (V_{ctrl.source}), wherein the decoupling circuitry (130; 420; 510) is configured to:
block a current path (105) from the RF switch terminal (120) to the decoupling circuitry (130; 420; 510) in response to a voltage at the RF switch (110) and the reference voltage (V_{ctrl.source}) satisfying a predetermined criterion.

2. The RF switch device (100; 300; 500; 600) of claim 1, wherein the decoupling circuitry (130; 420; 510) is configured to provide the current path (105) from the decoupling circuitry (130; 420; 510) to the RF switch terminal (120) when the criterion is not satisfied.

3. The RF switch device (100; 300; 500; 600) of claim 1 or 2, further comprising:
a bypass switch (310; 430) arranged in parallel to the decoupling circuitry (130; 420; 510) for bypassing the decoupling circuitry (130; 420; 510).

4. The RF switch device (100; 300; 500; 600) of any one of claims 1 to 3, wherein the reference voltage (V_{ctrl.source}) is representative of the control voltage, and wherein the predetermined criterion is that a voltage at the RF switch terminal (120) is lower than or equal to the reference voltage (V_{ctrl.source}).

5. The RF switch device (100; 300; 500; 600) of claim 4, wherein the decoupling circuitry (130; 420; 510) comprises a diode (410) to block the current path (105) from the decoupling circuitry (130; 420; 510) to the RF switch terminal (120).

6. The RF switch device (100; 300; 500; 600) of claim 4, wherein the decoupling circuitry (130; 420; 510) comprises a first transistor (M_{N1}) different from the plurality of transistors (150, 160) of the RF switch (110), wherein a control terminal (460) of the first transistor (M_{N1})is electrically connected to the RF switch terminal (120).

7. The RF switch device (100; 300; 500; 600) of claim 6, when dependent on claim 3, wherein the bypass switch (430) comprises a second transistor (M_{P1}) electrically connected in parallel to the first transistor (M_{N1}), wherein the second transistor (M_{P1}) is configured to provide a conductive path for bypassing the decoupling circuitry (420).

8. The RF switch device (100; 300; 500; 600) of claim 7, wherein the bypass switch (430) further comprises a third transistor (M_{N2}) electrically connected in parallel to the first transistor (M_{N1}) and the second transistor (M_{P1}), wherein a control terminal (440) of the third transistor (M_{N2}) is configured to receive a control signal for selectively controlling the second transistor (M_{P1}) to provide or block the conductive path for bypassing the decoupling circuitry (420).

9. The RF switch device (100; 300; 500; 600) of any one of the previous claims, further comprising, for at least one pair of adjacent transistors (150, 160) of the plurality of transistors (150, 160), a respective compensation circuit (190) configured to provide a dedicated current path between the pair of adjacent transistors (150, 160) in a first direction and block the current path in a second direction opposite to the first direction.

10. The RF switch device (100; 300; 500; 600) of claim 9 wherein, for at least one transistor of the plurality of transistors (150, 160) electrically connected in series, a bootstrapping circuit is electrically connected between a gate and a body of the at least one transistor (150, 160) and is configured to electrically connect the body with the gate when the RF switch (110) is in an OFF-state.

11. The RF switch device (100; 300; 500; 600) of any one of the previous claims, further comprising:
a shunt capacitor (610) electrically connected to the RF switch terminal (120) in parallel to the RF switch (110).

12. A wireless communication device (700) comprising an RF switch device (100; 300; 500; 600) according to any one of claims 1 to 11.

13. A method (800) of operating a radio frequency, RF, switch device (100; 300; 500; 600), comprising a RF switch (110) comprising a plurality of transistors (150, 160) arranged in series, and a terminal (120) configured to receive a control voltage (V_{ctrl.switch}) for controlling a switch state of the RF switch (110), and decoupling circuitry (130; 420; 510) configured to receive a reference voltage (V_{ctrl.source}), the method comprising:
blocking (810) a current path (105) from the RF switch terminal (120) to the decoupling circuitry (130; 420; 510), if a voltage at the RF switch and the reference voltage (V_{ctrl.source}) satisfy a predetermined criterion.

14. The method (800) of claim 13, wherein the RF switch device (100; 300; 500; 600) further comprises a bypass switch (310; 430) arranged in parallel to the decoupling circuitry (130; 420; 510), the method further comprising:
bypassing the decoupling circuitry (130; 420; 510).

15. The method (800) of claim 13 or 14, further comprising:
providing the current path (105) from the decoupling circuitry (130; 420; 510) to the RF switch terminal (120) when the criterion is not satisfied.
